(19) **Europäisches Patentamt / European Patent Office / Office européen des brevets**

(11) **EP 4 043 891 B1**

(12) **EUROPEAN PATENT SPECIFICATION**

(45) Date of publication and mention
of the grant of the patent:
**05.07.2023 Bulletin 2023/27**

(21) Application number: **21156823.3**

(22) Date of filing: **12.02.2021**

(51) International Patent Classification (IPC):
**G01R 27/02** (2006.01)     **G01R 31/00** (2006.01)

(52) Cooperative Patent Classification (CPC):
**G01R 27/025; G01R 31/006**

(54) **ISOLATION MEASUREMENT MONITORING FOR ASIL APPLICATIONS**

ISOLATIONSMESSUNGSÜBERWACHUNG FÜR ASIL-ANWENDUNGEN

SURVEILLANCE DE MESURE D'ISOLATION POUR LES APPLICATIONS ASIL

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**17.08.2022 Bulletin 2022/33**

(73) Proprietor: **Samsung SDI Co., Ltd.
Yongin-si, Gyeonggi-do 17084 (KR)**

(72) Inventors:
• **Fritz, Jürgen
8020 Graz (AT)**
• **Kurcik, Peter
8505 St. Nikolai im Sausal (AT)**
• **Reiter, Harald
8020 Graz (AT)**

(74) Representative: **Gulde & Partner
Patent- und Rechtsanwaltskanzlei mbB
Wallstraße 58/59
10179 Berlin (DE)**

(56) References cited:
**CN-A- 108 333 548      US-A1- 2007 285 102
US-A1- 2014 084 933      US-A1- 2020 088 803**

**Description**

The present invention refers to an electric circuit for monitoring isolation resistance measurement within the high voltage, HV, board net of an electronic vehicle (according to ISO 26262) and to a corresponding method for monitoring such an isolation resistance measurement.

**Technological Background**

Within the HV board net of an electronic vehicle (EV) and in particular of a plug-in-hybrid electronic vehicle (PHEV), the functional safety goal for measuring the isolation resistance(s) of comprised power systems is very often an assessment with Automotive Safety Integrity Level A (ASIL A) or sometimes even higher. These assessments are defined in ISO 26262, titled "Road vehicles - Functional safety", which is an international standard for functional safety of electrical and/or electronic systems in production automobiles.

Power systems typically have to comply with the elementary standard ECE R 100 for electromobility, which describes uniform regulations for vehicle systems. The standard requires, besides measuring the isolation resistance(s) of power systems, also monitoring said measuring. Several ways might be possible to realize an isolation resistance monitor (short: iso-monitor) which is also ASIL A compliant. An approach for iso-monitoring in general is to apply the method that is described in Annex 4A in ECE R 100.

This method of monitoring isolation resistance measurement requires two high voltage measurements and two current measurements. However, any measurement causes certain costs, complex hardware and software design and significant efforts during the design, including verification that the required accuracy and behaviour is achieved.

It is thus an object of the present invention to overcome or reduce at least some of the drawbacks of the prior art and to provide isolation resistance monitoring according to standard ECE R 100 that is also ASIL A compliant but requires a reduced number of measurements compared to the described prior art technique to reduce the costs and complexity of related isolation resistance monitor systems.

In this regard, US 2014/0084933 A1 discloses an isolation resistance measuring apparatus having a fault self-diagnosing function. US 2007/0285102 A1 relates to a corresponding measuring array with an earth connection point. CN 108333548 A provides an insulation resistance measurement device and a fault self-diagnosis method. US 2020/0088803 A1 concerns a system and a method for calculating insulation resistance.

**Summary of Invention**

The invention solves the objective problem by providing an electric circuit for monitoring isolation resistance measurement within the HV board net of an electronic vehicle as defined in claim 1 and by providing a corresponding method for monitoring an isolation resistance measurement as defined in claim 4.

An electric circuit according to the invention comprises a HV power system providing a positive high voltage potential and a negative high voltage potential, wherein a common ground potential is defined in the middle between a positive isolation resistance and a negative isolation resistance, the positive isolation resistance and the negative isolation resistance being connected in series and parallel to the HV power system between the positive high voltage potential and the negative high voltage potential.

The electric circuit further comprises a positive measurement resistance connected in parallel to the positive isolation resistance between the positive high voltage potential and the ground potential; a negative measurement resistance connected in parallel to the negative isolation resistance between the negative high voltage potential and the ground potential; a positive voltage meter between the positive high voltage potential and the ground potential; a negative voltage meter between the negative high voltage potential and the ground potential.

Furthermore, the electric circuit comprises only a single amperemeter permanently configured to measure either a positive current $I_{iso-p}$ through the positive measurement resistance between the positive high voltage potential and the ground potential, or a negative current $I_{iso-n}$ through the negative measurement resistance between the negative high voltage potential and the ground potential.

A HV power system can be, for example, a battery system (e.g. a rechargeable energy storage system, RESS) or a supply system. Preferably, the high voltage potentials or their potential difference can be $\pm 48$ volts, $\pm 60$ volts, $\pm 200$ volts, $\pm 400$ volts or $\pm 600$ volts. However, the high voltage potentials can be at any voltage higher than 6 volts (absolute value). The terms positive and negative are only used as identifiers for components or variables which are located in the respective section of the electric circuit, i.e., in the section related to the positive high voltage potential and in the section related to the negative high voltage potential. Positive currents and negative currents are thus currents related to the respective positive and negative sections of the electric circuit. The terms do not refer to the algebraic sign of any of these currents.

In an electric circuit according to the invention, only a single amperemeter is present. Therefore, the number of components is reduced compared to similar prior art electric circuits for monitoring isolation resistance measurement within the HV board net of an electronic vehicle. As one amperemeter can be omitted, with an electric circuit according to the invention the costs and complexity of isolation resistance monitor systems can be reduced.

The invention is based on the idea that a second amperemeter is not required because the prior art measurement approach is overdetermined with respect to the two measured currents. All required parameters can thus be determined also with a single current measurement, i.e., a measurement of a positive current $I_{iso\_p}$ through the positive measurement resistance between the positive high voltage potential and the ground potential, or a negative current $I_{iso\_n}$ through the negative measurement resistance between the negative high voltage potential and the ground potential. In other words, the invention provides isolation resistance monitoring with a cost- and effort-optimized diagnosis concept for ASIL applications which still complies with standard ECE R 100.

It is preferred that the positive current $I_{iso\_p}$ through the positive measurement resistance in relation to the ground potential can be controlled on or off by a positive switch. It is also preferred that the negative current $I_{iso\_n}$ through the negative measurement resistance in relation to the ground potential can be controlled on or off by a negative switch. The switches allow to activate or deactivate the respective isolation resistance measurement and to individually control the positive isolation resistance measurement section and the negative isolation resistance measurement section of the electric circuit.

A method for monitoring isolation resistance measurement within the HV board net of an electronic vehicle with an electric circuit according to the invention comprises measuring voltage $U_{BAT\_P}$ with the positive voltage meter between the positive high voltage potential and the ground potential as voltage drop across the positive isolation resistance and the positive measurement resistance connected in parallel; and measuring voltage $U_{BAT\_M}$ with the negative voltage meter between the negative high voltage potential and the ground potential as voltage drop across the negative isolation resistance and the negative measurement resistance connected in parallel. Afterwards calculating the actual positive isolation resistance value $R'_{IsoP}$ applying a known nominal positive measurement resistance value $R_{0\_p}$ of the positive measurement resistance and the measured voltage $U_{BAT\_P}$; and calculating the actual negative isolation resistance value $R'_{IsoN}$ applying a known nominal negative measurement resistance value $R_{0\_n}$ of the negative measurement resistance and the measured voltage $U_{BAT\_M}$. Further, measuring the current $I_{iso\_p}$ or $I_{iso\_n}$ through either the positive measurement resistance or the negative measurement resistance with the single amperemeter and calculating the respective actual measurement resistance value $R'_{0\_p}$ or $R'_{0\_n}$ of the measured positive measurement resistance or negative measurement resistance; and comparing the calculated respective actual measurement resistance value $R'_{0\_p}$ or $R'_{0\_n}$ of the measured positive measurement resistance or negative measurement resistance with the respective known nominal resistance value $R_{0\_p}$ or $R_{0\_n}$.

Preferably, the method further comprises calculating the respective actual measurement resistance value $R'_{0\_n}$ or $R'_{0\_p}$ of the unmeasured negative measurement resistance or positive measurement resistance applying the respective calculated actual measurement resistance value $R'_{0\_p}$ or $R'_{0\_n}$ of the measured positive measurement resistance or negative measurement resistance, the calculated actual positive isolation resistance value $R'_{IsoP}$ and the calculated negative isolation resistance value $R'_{IsoP}$; and comparing the calculated respective actual measurement resistance value $R'_{0\_n}$ or $R'_{0\_p}$ of the unmeasured negative measurement resistance or positive measurement resistance with the respective known nominal resistance value $R_{0\_n}$ or $R_{0\_p}$.

The actual isolation resistance values $R'_{IsoN}$ and $R'_{IsoN}$ are calculated (according to ECE R 100) by applying the known nominal positive measurement resistance value $R_{0\_p}$ of the positive measurement resistance and the known nominal negative measurement resistance value $R_{0\_n}$ of the negative measurement resistance, and the respective measured voltage of the corresponding high voltage potential section of the electric circuit.

The idea is that the two isolation resistances can still be measured according to the described standard prior art method. Monitoring the isolation resistance measurement can be done by diagnosing the actual measurement resistance values $R'_{0\_p}$ and/or $R'_{0\_n}$ of the two measurement resistances. The measured measurement resistance, i.e., the measurement resistance on which the current measurement was performed, can be simply calculated by dividing the respective measured voltage by the measured current and checked if it is as it should be.

The calculation of the respective actual measurement resistance value $R'_{0\_n}$ or $R'_{0\_p}$ of the unmeasured negative measurement resistance or positive measurement resistance can be done by applying Ohm's and Kirchhoff's laws as all relevant values ($R'_{IsoP}$, $R'_{IsoN}$, $R_{0\_p}$ or $R_{0\_n}$, $U_{BAT\_P}$, $U_{BAT\_M}$) except the respective unmeasured measurement resistance value $R_{0\_n}$ or $R_{0\_p}$ are already known. The following formulas can be used for this calculation:

$$R'_{0\_p} = \frac{U_{BAT\_P}}{I_{iso\_p}} \text{ and } R'_{0\_n} = \frac{R'_{0\_p} * R'_{IsoN} * R'_{IsoP} * U_{BAT\_M}}{R'_{0\_p} * R'_{IsoP} * U_{BAT\_M} + R'_{0\_p} * R'_{IsoN} * U_{BAT\_P} + R'_{IsoN} * R'_{IsoP} * U_{BAT\_P}},$$

$$R'_{0\_n} = \frac{U_{BAT\_M}}{I_{iso\_n}} \text{ and } R'_{0\_p} = \frac{R'_{0\_n} * R'_{IsoP} * R'_{IsoN} * U_{BAT\_N}}{R'_{0\_n} * R'_{IsoN} * U_{BAT\_N} + R'_{0\_n} * R'_{IsoP} * U_{BAT\_M} + R'_{IsoP} * R'_{IsoN} * U_{BAT\_M}}.$$

Preferably, the method is applied to the electric circuit when the positive switch and/or the negative switch is closed. If both switches are present and open, isolation resistance measurement is completely omitted.

In another aspect, the invention refers to a board net of an electronic vehicle, comprising an electric circuit according to the invention.

In yet another aspect, the invention refers to an electronic vehicle, comprising an electric circuit according to the invention.

Further preferred embodiments of the invention result from features mentioned in the dependent claims.

The various embodiments of the invention mentioned in this application can be combined with each other to advantage, unless otherwise specified in the particular case.

## Brief Description of the Drawings

In the following, the invention will be described in further detail by figures. The examples given are adapted to describe the invention. The figures show:

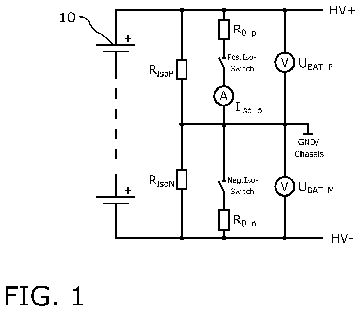

FIG. 1 a circuit diagram for monitoring isolation resistance measurement within the HV board net of an electronic vehicle according to an embodiment of the invention.

## Detailed Description of the Invention

Reference will now be made in detail to embodiments, examples of which are illustrated in the accompanying drawings. Effects and features of the exemplary embodiments, and implementation methods thereof will be described with reference to the accompanying drawings. In the drawings, like reference numerals denote like elements, and redundant descriptions are omitted. As used herein, the term "and/or" includes any and all combinations of one or more of the associated listed items. Further, the use of "may" when describing embodiments of the present invention refers to "one or more embodiments of the present invention."

It will be understood that although the terms "first" and "second" are used to describe various elements, these elements should not be limited by these terms. These terms are only used to distinguish one element from another element. For example, a first element may be named a second element and, similarly, a second element may be named a first element, without departing from the scope of the present invention.

In the following description of embodiments of the present invention, the terms of a singular form may include plural forms unless the context clearly indicates otherwise.

It will be further understood that the terms "include", "comprise", "including", or "comprising" specify a property, a region, a fixed number, a step, a process, an element, a component, and a combination thereof but do not exclude other properties, regions, fixed numbers, steps, processes, elements, components, and combinations thereof.

It will also be understood that when a film, a region, or an element is referred to as being "above" or "on" another film, region, or element, it can be directly on the other film, region, or element, or intervening films, regions, or elements may also be present.

In the drawings, the sizes of elements may be exaggerated for clarity. For example, in the drawings, the size or thickness of each element may be arbitrarily shown for illustrative purposes, and thus the embodiments of the present invention should not be construed as being limited thereto.

Features of the inventive concept and methods of accomplishing the same may be understood more readily by reference to the following detailed description of embodiments and the accompanying drawings. Hereinafter, example embodiments will be described in more detail with reference to the accompanying drawings, in which like reference numbers refer to like elements throughout. The present invention, however, may be embodied in various different forms, and should not be construed as being limited to only the illustrated embodiments herein. Rather, these embodiments are provided as examples so that this disclosure will be thorough and complete, and will fully convey the aspects and features of the present invention to those skilled in the art. Accordingly, processes, elements, and techniques that are not necessary to those having ordinary skill in the art for a complete understanding of the aspects and features of the present invention may not be described. Unless otherwise noted, like reference numerals denote like elements throughout the attached drawings and the written description, and thus, descriptions thereof will not be repeated. In the drawings, the relative sizes of elements, layers, and regions may be exaggerated for clarity.

It will be understood that, although the terms "first", "second", "third", etc., may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the scope of the present invention.

Spatially relative terms, such as "beneath", "below", "lower", "under", "above", "upper", and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below" or "beneath" or "under" other elements or features would then be oriented "above" the other elements or features. Thus, the example terms "below" and "under" can encompass both an orientation of above and below. The device may be otherwise oriented (e.g. rotated 90 degrees or at other orientations) and the spatially relative descriptors used herein should be interpreted accordingly.

It will be understood that when an element or layer is referred to as being "on", "connected to", or "coupled to" another element or layer, it can be directly on, connected to, or coupled to the other element or layer, or one or more intervening elements or layers may be present. In addition, it will also be understood that when an element or layer is referred to as being "between" two elements or layers, it can be the only element or layer between the two elements or layers, or one or more intervening elements or layers may also be present.

The terminology used herein is for the purpose of describing particular embodiments only and is not intended to be limiting of the present invention. As used herein, the singular forms "a", "an", and "the" are intended to include the plural forms as well, unless the context clearly indicates otherwise. It will be further understood that the terms "comprises", "comprising", "includes", and "including", when used in this specification, specify the presence of the stated features, integers, steps, operations, elements, and/or components, but do not preclude the presence or addition of one or more other features, integers, steps, operations, elements, components, and/or groups thereof. As used herein, the term "and/or" includes any and all combinations of one or more of the associated listed items. Expressions such as "at least one of", when preceding a list of elements, modify the entire list of elements and do not modify the individual elements of the list.

Unless otherwise defined, all terms (including technical and scientific terms) used herein have the same meaning as commonly understood by one of ordinary skill in the art to which the present invention belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

FIG. 1 shows a circuit diagram for monitoring isolation resistance measurement within the HV board net of an electronic vehicle according to an embodiment of the invention. The electric circuit comprises a HV power system 10 providing a positive high voltage potential HV+ and a negative high voltage potential HV-, wherein a common ground potential GND/Chassis is defined in the middle between a positive isolation resistance $R_{IsoP}$ and a negative isolation resistance $R_{IsoN}$, the positive isolation resistance $R_{IsoP}$ and the negative isolation resistance $R_{IsoN}$ being connected in series and parallel to the HV power system 10 between the positive high voltage potential HV+ and the negative high voltage potential HV-.

The electric circuit further comprises a positive measurement resistance $R_{0\_p}$ connected in parallel to the positive isolation resistance $R_{IsoP}$ between the positive high voltage potential HV+ and the ground potential GND/Chassis; a negative measurement resistance $R_{0\_n}$ connected in parallel to the negative isolation resistance $R_{IsoN}$ between the negative high voltage potential HV- and the ground potential GND/Chassis; a positive voltage meter $U_{BAT\_P}$ between the positive high voltage potential HV+ and the ground potential GND/Chassis; a negative voltage meter $U_{BAT\_N}$ between the negative high voltage potential HV- and the ground potential GND/Chassis.

The electric circuit comprises only a single amperemeter $I_{iso\_p}$ or $I_{iso\_n}$ (only the embodiment with amperemeter $I_{iso\_p}$ is shown in FIG. 1) permanently configured to measure either a positive current $I_{iso\_p}$ through the positive measurement resistance $R_{0\_p}$ between the positive high voltage potential HV+ and the ground potential GND/Chassis, or a negative current $I_{iso\_n}$ through the negative measurement resistance $R_{0\_n}$ between the negative high voltage potential HV- and the ground potential GND/Chassis. The positive current $I_{iso\_p}$ through the positive measurement resistance $R_{0\_p}$ in relation to the ground potential GND/Chassis can be controlled on or off by a positive switch Pos.Iso-Switch. The negative current $I_{iso\_p}$ through the negative measurement resistance $R_{0\_p}$ in relation to the ground potential GND/Chassis can be controlled on or off by a negative switch Neg.Iso-Switch.

For isolation resistance measurement, based on measured voltages $U_{SAT\_P}$ (between the positive high voltage potential HV+ and the ground potential GND/Chassis) and $U_{BAT\_N}$ (between the negative high voltage potential HV- and the ground potential GND/Chassis), the respective actual isolation resistance values $R'_{IsoP}$ and $R'_{IsoN}$ of the isolation resistances $R_{IsoP}$ and $R_{IsoN}$ can also be calculated by applying Ohm's law with known nominal resistance values $R_{0\_p}$ and $R_{0\_n}$ and compared with respective known nominal isolation resistance values $R_{IsoP}$ and $R_{IsoN}$. A deviation between $R'_{IsoP}$ and $R_{IsoP}$ and/or between $R'_{IsoP}$ and $R_{IsoN}$ can be an indication of an error in the insulation resistance.

However, for monitoring the isolation resistance measurement, the current $I_{iso\_p}$ or $I_{iso\_n}$ through either the positive measurement resistance $R_{0\_p}$ or the negative measurement resistance $R_{0\_n}$ is measured with the single amperemeter $I_{iso\_p}$ or $I_{iso\_n}$ and based on the respective measured voltages $U_{BAT\_P}$ (between the positive high voltage potential HV+ and the ground potential GND/Chassis) or $U_{BAT\_N}$ (between the negative high voltage potential HV- and the ground potential GND/Chassis), the respective actual measurement resistance value $R'_{0\_p}$ or $R'_{0\_n}$ of the measured measurement resistance value $R'_{0\_p}$ or $R'_{0\_n}$ can be calculated by applying Ohm's law and compared with the respective known nominal measurement resistance value $R'_{0\_p}$ or $R_{0\_n}$. A respective deviation between $R'_{0\_p}$ and $R'_{0\_p}$ or between $R'_{0\_n}$ and $R_{0\_n}$ can be an indication of an error in the insulation resistance measurement.

In addition, the respective actual measurement resistance value $R'_{0\_n}$ or $R'_{0\_p}$ of the unmeasured measurement resistance $R_{0\_n}$ or $R_{0\_p}$ can be calculated applying the respective calculated actual measurement resistance value $R'_{0\_p}$ or $R'_{0\_n}$ of the measured measurement resistance $R_{0\_p}$ or $R_{0\_n}$, the calculated actual positive isolation resistance value $R'_{IsoP}$ and the negative isolation resistance value $R'_{IsoP}$, and compared with a respective known nominal resistance value $R_{0\_n}$ or $R_{0\_p}$. A respective deviation between $R'_{0\_n}$ and $R_{0\_n}$ or between $R'_{0\_p}$ and $R'_{0\_p}$ can be an indication of an error in the insulation resistance measurement. This method of monitoring isolation resistance measurement according to the invention requires two high voltage measurements and only one current measurement.

**Reference List**

10    HV power system (e.g. battery systems or supply system)

HV+           positive high voltage potential
HV-           negative high voltage potential
GND/Chassis   (chassis) ground

$R_{IsoP}$    positive isolation resistance (value $R_{IsoP}$ nominal, $R'_{IsoP}$ measured)
$R_{IsoN}$    negative isolation resistance (value $R_{IsoN}$ nominal, $R'_{IsoN}$ measured)
$R_{0\_p}$    positive measurement resistance (value $R'_{0\_p}$ nominal, $R'_{0\_p}$ measured)
$R_{0\_n}$    negative measurement resistance (value $R'_{0\_n}$ nominal, $R'_{0\_n}$ measured)

$U_{BAT\_P}$    positive voltage meter (value $U_{BAT\_P}$)
$U_{BAT\_M}$    negative voltage meter (value $U_{BAT\_N}$)
$I_{iso\_p}$    (positive) amperemeter (value $I_{iso\_p}$)
$I_{iso\_n}$    (negative) amperemeter (value $I_{iso\_n}$)

Pos.Iso-Switch    positive switch
Neg.Iso-Switch    negative switch

**Claims**

1. Electric circuit for monitoring isolation resistance measurement within the high voltage, HV, board net of an electronic vehicle, comprising:

   a HV power system (10) providing a positive high voltage potential (HV+) and a negative high voltage potential (HV-), wherein a common ground potential (GND/Chassis) is defined in the middle between a positive isolation resistance ($R_{IsoP}$) and a negative isolation resistance ($R_{IsoN}$), the positive isolation resistance ($R_{IsoP}$) and the negative isolation resistance ($R_{IsoN}$) being connected in series and parallel to the HV power system (10) between the positive high voltage potential (HV+) and the negative high voltage potential (HV-);
   a positive measurement resistance ($R_{0\_p}$) connected in parallel to the positive isolation resistance ($R_{IsoP}$) between the positive high voltage potential (HV+) and the ground potential (GND/Chassis);
   a negative measurement resistance ($R_{0\_n}$) connected in parallel to the negative isolation resistance ($R_{IsoN}$) between the negative high voltage potential (HV-) and the ground potential (GND/Chassis);
   a positive voltage meter ($U_{BAT\_P}$) between the positive high voltage potential (HV+) and the ground potential (GND/Chassis);
   a negative voltage meter ($U_{BAT\_N}$) between the negative high voltage potential (HV-) and the ground potential (GND/Chassis);
   **characterized in that**
   the electric circuit further comprises only a single amperemeter ($I_{iso\_p}$ or $I_{iso\_n}$) permanently configured to measure either a positive current $I_{iso\_p}$ through the positive measurement resistance ($R_{0\_p}$) between the positive high voltage potential (HV+) and the ground potential (GND/Chassis), or a negative current $I_{iso\_n}$ through the negative measurement resistance ($R_{0\_n}$) between the negative high voltage potential (HV-) and the ground potential (GND/Chassis).

2. Electric circuit according to claim 1, wherein the positive current $I_{iso\_p}$ through the positive measurement resistance ($R_{0\_p}$) in relation to the ground potential (GND/Chassis) can be controlled on or off by a positive switch (Pos.Iso-Switch).

3. Electric circuit according to claim 1 or 2, wherein the negative current $I_{iso\_n}$ through the negative measurement resistance ($R_{0\_n}$) in relation to the ground potential (GND/Chassis) can be controlled on or off by a negative switch (Neg.Iso-Switch).

4. Method for monitoring isolation resistance measurement within the HV board net of an electronic vehicle with an electric circuit according to one of the preceding claims, wherein the method comprises:

- measuring voltage $U_{BAT\_P}$ with the positive voltage meter ($U_{BAT\_P}$) between the positive high voltage potential (HV+) and the ground potential (GND/Chassis) as voltage drop across the positive isolation resistance ($R_{IsoP}$) and the positive measurement resistance ($R_{0\_p}$) connected in parallel;
- measuring voltage $U_{BAT\_M}$ with the negative voltage meter ($U_{BAT\_M}$) between the negative high voltage potential (HV-) and the ground potential (GND/Chassis) as voltage drop across the negative isolation resistance ($R_{IsoN}$) and the negative measurement resistance ($R_{0\_n}$) connected in parallel;
- calculating the actual positive isolation resistance value $R'_{IsoP}$ applying a known nominal positive measurement resistance value $R'_{0\_p}$ of the positive measurement resistance ($R_{0\_p}$) and the measured voltage $U_{BAT\_P}$;
- calculating the actual negative isolation resistance value $R'_{IsoN}$ applying a known nominal negative measurement resistance value $R_{0\_n}$ of the negative measurement resistance ($R_{0\_n}$) and the measured voltage $U_{BAT\_M}$;
- measuring the current ($I_{iso\_p}$ or $I_{iso\_n}$) through either the positive measurement resistance ($R_{0\_p}$) or the negative measurement resistance ($R_{0\_n}$) with the single amperemeter ($I_{iso\_p}$ or $I_{iso\_n}$) and calculating the respective actual measurement resistance value $R'_{0\_p}$ or $R'_{0\_n}$ of the measured positive measurement resistance ($R_{0\_p}$) or negative measurement resistance ($R_{0\_n}$);
- comparing the calculated respective actual measurement resistance value $R'_{0\_p}$ or $R'_{0\_n}$ of the measured positive measurement resistance ($R_{0\_p}$) or negative measurement resistance ($R_{0\_n}$) with the respective known nominal resistance value $R'_{0\_p}$ or $R_{0\_n}$.

5. Method according to claim 4, further comprising:

- calculating the respective actual measurement resistance value $R'_{0\_n}$ or $R'_{0\_p}$ of the unmeasured negative measurement resistance ($R_{0\_n}$) or positive measurement resistance ($R_{0\_p}$) applying the respective calculated actual measurement resistance value $R'_{0\_p}$ or $R'_{0\_n}$ of the measured positive measurement resistance ($R_{0\_p}$) or negative measurement resistance ($R_{0\_n}$), the calculated actual positive isolation resistance value $R'_{IsoP}$ and the calculated negative isolation resistance value $R'_{IsoP}$;
- comparing the calculated respective actual measurement resistance value $R'_{0\_n}$ or $R'_{0\_p}$ of the unmeasured negative measurement resistance ($R_{0\_n}$) or positive measurement resistance ($R_{0\_p}$) with the respective known nominal resistance value $R_{0\_n}$ or $R_{0\_p}$.

6. Method according to claim 4 or 5, wherein the method is applied to the electric circuit when the positive switch (Pos.Iso-Switch) and/or the negative switch (Neg.Iso-Switch) is closed.

7. Board net of an electronic vehicle, comprising an electric circuit for monitoring isolation resistance measurement according to claims 1 to 3.

8. Electronic vehicle, comprising an electric circuit for monitoring isolation resistance measurement according to claims 1 to 3.

**Patentansprüche**

1. Elektrische Schaltung zur Überwachung der Isolationswiderstandsmessung innerhalb des Hochspannungs-HV-Bordnetzes eines elektronischen Fahrzeugs, umfassend:

ein Hochspannungs-Energiesystem (10), das ein positives Hochspannungspotential (HV+) und ein negatives Hochspannungspotential (HV-) bereitstellt, wobei ein gemeinsames Massepotential (GND/Chassis) in der Mitte zwischen einem positiven Isolationswiderstand ($R_{IsoP}$) und einem negativen Isolationswiderstand ($R_{IsoN}$) definiert ist, wobei der positive Isolationswiderstand ($R_{IsoP}$) und der negative Isolationswiderstand ($R_{IsoN}$) in Reihe und parallel mit dem HV-Energiesystem (10) zwischen dem positiven Hochspannungspotential (HV+) und dem negativen Hochspannungspotential (HV-) geschaltet sind;

einen positiven Messwiderstand ($R_{0\_p}$), der mit dem positiven Isolationswiderstand ($R_{IsoP}$) zwischen dem positiven Hochspannungspotential (HV+) und dem Massepotential (GND/Chassis) parallel geschaltet ist;

einen negativen Messwiderstand ($R_{0\_n}$), der mit dem negativen Isolationswiderstand ($R_{IsoN}$) zwischen dem negativen Hochspannungspotential (HV-) und dem Massepotential (GND/Chassis) parallel geschaltet ist;

einen positiven Spannungsmesser ($U_{BAT\_P}$) zwischen dem positiven Hochspannungspotential (HV+) und dem Massepotential (GND/Chassis);

einen negativen Spannungsmesser ($U_{BAT\_N}$) zwischen dem negativen Hochspannungspotential (HV-) und dem Massepotential (GND/Chassis);

**dadurch gekennzeichnet, dass**

die elektrische Schaltung ferner nur ein einziges Amperemeter ($I_{iso\_p}$ oder $I_{iso\_n}$) umfasst, das permanent so konfiguriert ist, dass es entweder einen positiven Strom $I_{iso\_p}$ durch den positiven Messwiderstand ($R_{0\_p}$) zwischen dem positiven Hochspannungspotenzial (HV+) und dem Massepotenzial (GND/Chassis) oder einen negativen Strom $I_{iso\_n}$ durch den negativen Messwiderstand ($R_{0\_n}$) zwischen dem negativen Hochspannungspotenzial (HV-) und dem Massepotenzial (GND/Chassis) misst.

2. Elektrische Schaltung nach Anspruch 1, wobei der positive Strom $I_{iso\_p}$ durch den positiven Messwiderstand ($R_{0\_p}$) in Bezug auf das Massepotential (GND/Chassis) durch einen positiven Schalter (Pos.Iso-Switch) steuerbar ist, um ein- oder ausgeschaltet zu sein.

3. Elektrische Schaltung nach Anspruch 1 oder 2, wobei der negative Strom $I_{iso\_n}$ durch den negativen Messwiderstand ($R_{0\_n}$) in Bezug auf das Massepotential (GND/Chassis) durch einen negativen Schalter (Neg.Iso-Switch) steuerbar ist, um ein- oder ausgeschaltet zu sein.

4. Verfahren zur Überwachung der Isolationswiderstandsmessung innerhalb des HV-Bordnetzes eines elektronischen Fahrzeugs mit einer elektrischen Schaltung nach einem der vorhergehenden Ansprüche, wobei das Verfahren umfasst:

- Messen einer Spannung $U_{BAT\_P}$ mit dem positiven Spannungsmesser ($U_{BAT\_P}$) zwischen dem positiven Hochspannungspotential (HV+) und dem Massepotential (GND/Chassis) als Spannungsabfall über den positiven Isolationswiderstand ($R_{IsoP}$) und den parallel geschalteten positiven Messwiderstand ($R_{0\_p}$) ;

- Messen einer Spannung $U_{BAT\_M}$ mit dem negativen Spannungsmesser ($U_{BAT\_M}$) zwischen dem negativen Hochspannungspotential (HV-) und dem Massepotential (GND/Chassis) als Spannungsabfall über den negativen Isolationswiderstand ($R_{IsoN}$) und den parallel geschalteten negativen Messwiderstand ($R_{0\_n}$);

- Berechnen des tatsächlichen positiven Isolationswiderstandswertes $R'_{IsoP}$ unter Verwendung eines bekannten nominalen positiven Messwiderstandswertes $R_{0\_p}$ des positiven Messwiderstandes ($R_{0\_p}$) und der gemessenen Spannung $U_{BAT\_P}$ ;

- Berechnen des tatsächlichen negativen Isolationswiderstandswertes $R'_{IsoN}$ unter Verwendung eines bekannten nominalen negativen Messwiderstandswertes $R_{0\_n}$ des negativen Messwiderstandes ($R_{0\_n}$) und der gemessenen Spannung $U_{BAT\_M}$ ;

- Messen des Stroms ($I_{iso\_p}$ bzw. $I_{iso\_n}$) entweder durch den positiven Messwiderstand ($R_{0\_p}$) oder den negativen Messwiderstand ($R_{0\_n}$) mit dem Einzelamperemeter ($I_{iso\_p}$ bzw. $I_{iso\_n}$) und Berechnen des jeweiligen tatsächlichen Messwiderstands-Werts $R'_{0\_p}$ oder $R'_{0\_n}$ des gemessenen positiven Messwiderstands ($R_{0\_p}$) oder negativen Messwiderstands ($R_{0\_n}$) ;

- Vergleichen des berechneten jeweiligen tatsächlichen Messwiderstandswertes $R'_{0\_p}$ bzw. $R'_{0\_n}$ des gemessenen positiven Messwiderstandes ($R_{0\_p}$) oder negativen Messwiderstandes ($R_{0\_n}$) mit dem jeweils bekannten nominalen Widerstandswert $R'_{0\_p}$ bzw. $R_{0\_n}$.

5. Verfahren nach Anspruch 4, ferner umfassend:

- Berechnen des jeweiligen tatsächlichen Messwiderstandswertes $R'_{0\_n}$ bzw. $R'_{0\_p}$ des ungemessenen negativen Messwiderstandes ($R_{0\_n}$) oder positiven Messwiderstandes ($R_{0\_p}$) unter Verwendung des jeweiligen tatsächlichen Messwiderstandswertes $R'_{0\_p}$ oder $R'_{0\_n}$ des gemessenen positiven Messwiderstandes ($R_{0\_p}$) oder negativen Messwiderstandes ($R_{0\_n}$), des berechneten positiven tatsächlichen Isolationswiderstandswertes

$R'_{IsoP}$ und des berechneten negativen Isolationswiderstandes $R'_{IsoP}$;
- Vergleichen des berechneten jeweiligen tatsächlichen Messwiderstandswertes $R'_{0\_n}$ bzw. $R'_{0\_p}$ des ungemessenen negativen Messwiderstandes ($R_{0\_n}$) oder positiven Messwiderstandes ($R_{0\_p}$) mit dem jeweils bekannten nominalen Widerstandswert $R_{0\_n}$ bzw. $R_{0\_p}$.

6. Verfahren nach Anspruch 4 oder 5, wobei das Verfahren auf die elektrische Schaltung angewendet wird, wenn der
positive Schalter (Pos.Iso-Switch) und/oder der negative Schalter (Neg.Iso-Switch) geschlossen sind/ist.

7. Bordnetz eines elektronischen Fahrzeugs umfassend eine elektrische Schaltung zur Überwachung der Isolationswiderstandsmessung nach den Ansprüchen 1 bis 3.

8. Elektronisches Fahrzeug, das eine elektrische Schaltung zur Überwachung der Isolationswiderstandsmessung nach
den Ansprüchen 1 bis 3 umfasst.

**Revendications**

1. Circuit électrique pour surveiller une mesure de résistance d'isolement dans le réseau de carte haute tension, HT,
d'un véhicule électronique, comprenant :

   un système d'alimentation HT (10) fournissant un potentiel de haute tension positif (HV+) et un potentiel de
   haute tension négatif (HV-), dans lequel un potentiel de masse (GND/Chassis) commun est défini au milieu
   entre une résistance d'isolement positive ($R_{IsoP}$) et une résistance d'isolement négative ($R_{IsoN}$), la résistance
   d'isolement positive ($R_{IsoP}$) et la résistance d'isolement négative ($R_{IsoN}$) étant connectées en série et en parallèle
   au système d'alimentation HT (10) entre le potentiel de haute tension positif (HV+) et le potentiel de haute
   tension négatif (HV-) ;
   une résistance de mesure positive ($R_{0\_p}$) connectée en parallèle à la résistance d'isolement positive ($R_{IsoP}$)
   entre le potentiel de haute tension positif (HV+) et le potentiel de masse (GND/Chassis) ;
   une résistance de mesure négative ($R_{0\_n}$) connectée en parallèle à la résistance d'isolement négative ($R_{IsoN}$)
   entre le potentiel de haute tension négatif (HV-) et le potentiel de masse (GND/Chassis) ;
   un voltmètre de tension positive ($U_{BAT\_P}$) entre le potentiel de haute tension positif (HV+) et le potentiel de
   masse (GND/Chassis) ;
   un voltmètre de tension négative ($U_{BAT\_N}$) entre le potentiel de haute tension négatif (HV-) et le potentiel de
   masse (GND/Chassis) ;
   **caractérisé en ce que**
   le circuit électrique comprend en outre un seul ampèremètre ($I_{ISO\_p}$ ou $I_{ISO\_n}$) configuré en permanence pour
   mesurer soit un courant positif $I_{ISO\_p}$ à travers la résistance de mesure positive ($R_{0\_p}$) entre le potentiel de
   haute tension positif (HV+) et le potentiel de masse (GND/Chassis), soit un courant négatif $I_{ISO\_n}$ à travers la
   résistance de mesure négative ($R_{0\_n}$) entre le potentiel de haute tension négatif (HV-) et le potentiel de masse
   (GND/Chassis).

2. Circuit électrique selon la revendication 1, dans lequel le courant positif $I_{ISO\_p}$ à travers la résistance de mesure
positive ($R_{0\_p}$) par rapport au potentiel de masse (GND/Chassis) peut être commandé en marche ou en arrêt par
un commutateur positif (Pos.Iso-Switch).

3. Circuit électrique selon la revendication 1 ou 2, dans lequel le courant négatif $I_{ISO\_n}$ à travers la résistance de mesure
négative ($R_{0\_n}$) par rapport au potentiel de masse (GND/Chassis) peut être commandé en marche ou en arrêt par
un commutateur négatif (Neg.Iso-Switch).

4. Procédé pour surveiller une mesure de résistance d'isolement dans le réseau de carte HT d'un véhicule électronique
avec un circuit électrique selon l'une des revendications précédentes, le procédé comprenant les étapes consistant
à :

   - mesurer une tension $U_{BAT\_P}$ avec le voltmètre de tension positive ($U_{BAT\_P}$) entre le potentiel de haute tension
   positif (HV+) et le potentiel de masse (GND/Chassis) comme chute de tension aux bornes de la résistance
   d'isolement positive ($R_{IsoP}$) et de la résistance de mesure positive ($R_{0\_p}$) connectées en parallèle ;
   - mesurer une tension $U_{BAT\_M}$ avec le voltmètre de tension négative ($U_{BAT\_M}$) entre le potentiel de haute tension
   négatif (HV-) et le potentiel de masse (GND/Chassis) comme chute de tension aux bornes de la résistance d'isolement négative ($R_{IsoN}$) et de la résistance de mesure négative ($R_{0\_n}$) connectées en parallèle ;
- calculer la valeur réelle de résistance d'isolement positive $R'_{IsoP}$ en appliquant une valeur nominale connue de résistance de mesure positive $R'_{0\_p}$ de la résistance de mesure positive ($R_{0\_p}$) et de la tension mesurée $U_{BAT\_P}$ ;
- calculer la valeur réelle de résistance d'isolement négative $R'_{IsoN}$ en appliquant une valeur nominale connue de résistance de mesure négative $R_{0\_n}$ de la résistance de mesure négative ($R_{0\_n}$) et de la tension mesurée $U_{BAT\_M}$ ;
- mesurer le courant ($I_{ISO\_p}$ ou $I_{ISO\_n}$) soit à travers la résistance de mesure positive ($R_{0\_p}$) soit à travers la résistance de mesure négative ($R_{0\_n}$) avec le seul ampèremètre ($I_{ISO\_p}$ ou $I_{ISO\_n}$), et calculer la valeur réelle de résistance de mesure $R'_{0\_p}$ ou $R'_{0\_n}$ respective de la résistance de mesure positive ($R_{0\_p}$) ou de la résistance de mesure négative ($R_{0\_n}$) mesurées ;
- comparer la valeur réelle de résistance de mesure $R'_{0\_p}$ ou $R'_{0\_n}$ respective calculée de la résistance de mesure positive ($R_{0\_p}$) ou de la résistance de mesure négative ($R_{0\_n}$) mesurées avec la valeur de résistance nominale $R'_{0\_p}$ ou $R_{0\_n}$ respective connue.

**5.** Procédé selon la revendication 4, comprenant en outre les étapes consistant à :

- calculer la valeur réelle de résistance de mesure $R'_{0\_n}$ ou $R'_{0\_p}$ respective de la résistance de mesure négative ($R_{0\_n}$) ou de la résistance de mesure positive ($R_{0\_p}$) non mesurées en appliquant la valeur réelle de résistance de mesure $R'_{0\_p}$ ou $R'_{0\_n}$ respective calculée de la résistance de mesure positive ($R_{0\_p}$) ou de la résistance de mesure négative ($R_{0\_n}$) mesurées, la valeur réelle de résistance d'isolement positive calculée $R'_{IsoP}$ et la valeur de résistance d'isolement négative calculée $R'_{IsoP}$;
- comparer la valeur réelle de résistance de mesure $R'_{0\_n}$ ou $R'_{0\_p}$ respective calculée de la résistance de mesure négative ($R_{0\_n}$) ou de la résistance de mesure positive ($R_{0\_p}$) non mesurées avec la valeur de résistance nominale $R_{0\_n}$ ou $R_{0\_p}$ respective connue.

**6.** Procédé selon la revendication 4 ou 5, le procédé étant appliqué au circuit électrique lorsque le commutateur positif (Pos.Iso-Switch) et/ou le commutateur négatif (Neg.Iso-Switch) est fermé.

**7.** Réseau de carte d'un véhicule électronique, comprenant un circuit électrique pour surveiller une mesure de résistance d'isolement selon les revendications 1 à 3.

**8.** Véhicule électronique, comprenant un circuit électrique pour surveiller une mesure de résistance d'isolement selon les revendications 1 à 3.

FIG. 1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20140084933 A1
- US 20070285102 A1
- CN 108333548 A
- US 20200088803 A1